# EUROPEAN PATENT SPECIFICATION

(11) **EP 0 949 352 B1**
(45) Date of publication and mention of the grant of the patent: **31.07.2002**
(21) Application number: 99102642.8
(22) Date of filing: 12.02.1999
(51) Int. Cl.: C23C 16/50

(54) **Plasma CVD apparatus**
Plasma-CVD-Apparat
Appareil CVD à plasma

(30) Priority: 08.04.1998 JP 9598998
(43) Date of publication of application: 13.10.1999
(73) Proprietor: Mitsubishi Heavy Industries, Ltd., Tokyo 100-0005 (JP)
(72) Inventor: Murata, Masayoshi NAGASAKI Research & Devel. Cent., 5-chome, Nagasaki, Nagasaki-ken (JP); Takeuchi, Yoshiaki NAGASAKI Research & Devel. Cent, 5-chome, Nagasaki, Nagasaki-ken (JP); Serizawa, Satoru NAGASAKI Shipyard & Machine Works, Nagasaki, Nagasaki-ken (JP); Nawata, Yoshikazu NAGASAKI Shipyard Machine Works, Nagasaki, Nagasaki-ken (JP); Ogawa, Kazuhiko NAGASAKI Shipyard & Machine Works, Nagasaki, Nagasaki-ken (JP)
(74) Representative: Lins, Edgar, Dipl.-Phys. Dr.jur.

(56) References cited:
- DATABASE WPIL, week 9818, Derwent Publications Ltd., London GB, AN 98-199215, class C 23 C, XP002900502 & JP 10050614 A (MITSUBISHI JUKOGYO KK)
- DATABASE WPIL, week 9708, Derwent Publications Ltd., London GB, AN 97-083345, class C 30 B. XP002900503 & JP 08325092 A (MITSUBISHI JUKOGYO KK)
- DATABASE WPIL, week 9240, Derwent Publications Ltd., London GB, AN 92-328617, class C 23 C, XP002900504 & JP 04236781 A (MITSUBISHI HEAVY IND. CO. LTD.)

## Description

The present invention relates to a plasma CVD (Chemical Vapor Deposition) apparatus for preparation of a thin film used in various electronic devices such as an amorphous silicon solar cell, a microcrystalline solar cell, a thin film polycrystalline solar cell, a thin film semiconductor device, an optical sensor, and a semiconductor protective film.

Various plasma CVD apparatuses are used for preparation of an amorphous silicon (hereinafter referred to as "a-Si") thin film, a microcrystalline thin film, a polycrystalline thin film, or a silicon nitride (hereinafter referred to as SiNx") thin film. The conventional plasma CVD apparatus can be classified typically into a type in which is used a ladder-shaped electrode for discharge generation and another type in which are used plate electrodes arranged in parallel. The ladder-shaped electrode includes, for example, a ladder-antenna electrode, a ladder inductance electrode and a ladder-shaped plane coil electrode.

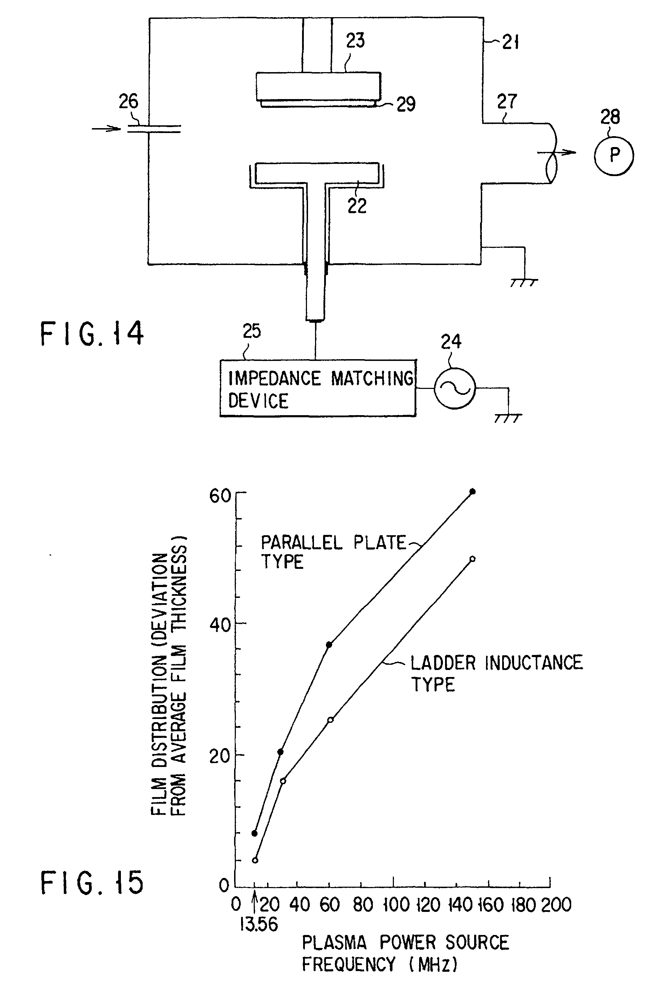

Japanese Patent Disclosure (Kokai) No. 4-236781 discloses a plasma CVD apparatus using a ladder-shaped electrode of various shapes. FIG. 12 shows a typical example of the plasma CVD apparatus disclosed in JP '781 quoted above. As shown in the drawing, a ladder-shaped electrode 2 for discharge generation and a heater 3 for heating a substrate are arranged in parallel within a reaction vessel 1. A high frequency power having a frequency of, for example, 13.56 MHz is supplied from a high frequency power source 4 to the ladder-shaped electrode 2 for discharge generation through an impedance matching device 5. As shown in FIG. 13, the ladder-shaped electrode 2 for discharge generation is connected at one end to the high frequency power source 4 via the impedance matching device 5 and is also connected at the other end to a ground wire 7 and, thus, to the ground. Also, the reaction vessel 1 is connected to the ground.

The high frequency power supplied to the ladder-shaped electrode 2 for discharge generation serves to generate a glow discharge plasma in a free space between the substrate heater 3, which is also connected to the ground together with the reaction vessel 1, and ladder-shaped electrode 2 for discharge generation. After generation of the glow discharge plasma, the high frequency power flows through the discharge space into the wall of the reaction vessel 1 and into the ground through the ground wire 7 connected to the ladder-shaped electrode 2. A coaxial cable is used as the ground wire 7.

A mixed gas consisting of, for example, monosilane and hydrogen is supplied from a bomb (not shown) into the reaction vessel 1 through a reactant gas introducing pipe 8. The reactant gas introduced into the reaction vessel 1 is decomposed by a glow discharge plasma generated by the ladder-shaped electrode 2 for discharge generation so as to be deposited on a substrate 9 disposed on the heater 3 and heated to a predetermined temperature. On the other hand, the gas within the reaction vessel 1 is exhausted by a vacuum pump 11 through an exhaust pipe 10.

In preparing a thin film by using the apparatus described above, the inner space of the reaction vessel 1 is exhausted first by operating the vacuum pump 11, followed by introducing a mixed gas consisting of, for example, monosilane and hydrogen into the reaction vessel 1 through the reactant gas introducing pipe 8. In this step, the inner pressure of the reaction vessel 1 is maintained at 6,6661 to 66,661 Pa. Under this condition, a high frequency power is supplied from the high frequency power source 4 to the ladder-shaped electrode 2 for discharge generation so as to generate a glow discharge plasma. Therefore, the reactant gas is decomposed by the glow discharge plasma generated in the free space between the ladder-shaped electrode 2 and the substrate heater 3 so as to generate Si-containing radicals SiH₃, and SiH_{2.} These radicals are attached to a surface of the substrate 9 so as to form an a-Si thin film.

FIG. 14 shows another type of the conventional plasma CVD apparatus in which are used plate electrodes arranged in parallel. As shown in the drawing, the apparatus comprises a reaction vessel 21. A high frequency electrode 22 and a substrate heater 23 are arranged in parallel within the reaction vessel 21. A high frequency having a frequency of, for example, 13.56 MHz is supplied from a high frequency power source 24 to the high frequency electrode 22 through an impedance matching device 25. The substrate heater 23 is connected to the reaction vessel 21. Also, the reaction vessel 21 is connected to the ground. It follows that the substrate heater 23 is indirectly connected to the ground to constitute a ground electrode, with the result that a glow discharge plasma is generated in the free space between the high frequency electrode 22 and the substrate heater 23.

A mixed gas consisting of, for example, monosilane and hydrogen is supplied from a bomb (not shown) into the reaction vessel 21 through a reactant gas introducing pipe 26. On the other hand, the gas within the reaction vessel 21 is exhausted by a vacuum pump 28 through an exhaust pipe 27. A substrate 29 is disposed on the substrate heater 23 so as to be heated to a predetermined temperature.

For forming a thin film by using the apparatus shown in FIG. 14, the inner space of the reaction vessel 21 is exhausted first by operating the vacuum pump 28, followed by introducing a mixed gas consisting of, for example, monosilane and hydrogen into the reaction vessel 21 through the reactant gas introducing pipe 26. In this step, the inner pressure of the reaction vessel 1 is maintained at 6,6661 to 66,661 Pa. If a high frequency power is supplied from the high frequency power source 24 to the high frequency electrode 22, a glow discharge plasma is generated within the reaction vessel.

The monosilane gas contained in the mixed gas supplied through the reactant gas introducing pipe 26 into the reaction vessel 21 is decomposed by the glow discharge plasma generated in the free space between the high frequency electrode 22 and the substrate heater 23 so as to generate Si-containing radicals such as SiH₃ and SiH₂. These Si-containing radicals are attached to a surface of the substrate 29 so as to form an a-Si thin film.

However, any of the prior arts using a ladder-shaped electrode and plate electrodes arranged in parallel gives rise to problems as described below.

(1) In the apparatus shown in FIG. 12, a reactant gas, e.g., SiH₄, is decomposed by an electric field generated in the vicinity of the ladder-shaped electrode 2 into Si, SiH, SiH₂, SiH₃, H, H₂, etc. so as to form an a-Si film on the surface of the substrate 9. However, if the frequency of the high frequency power is increased from the present level of 13.56 MHz to 30 to 200 MHz in an attempt to increase the rate of forming the a-Si film, the electric field in the vicinity of the ladder-shaped electrode fails to be distributed uniformly, leading to a markedly poor uniformity in the thickness of the formed a-Si film. FIG. 15 is a graph showing the relationship between the plasma power source frequency and the film thickness distribution in respect of a substrate having an area of 30 cm × 30 cm. It should be noted that the size of the substrate which permits ensuring a uniformity in the film thickness distribution, i.e., deviation of ±10% from an average film thickness, is 5 cm × 5 cm to 20 cm × 20 cm.

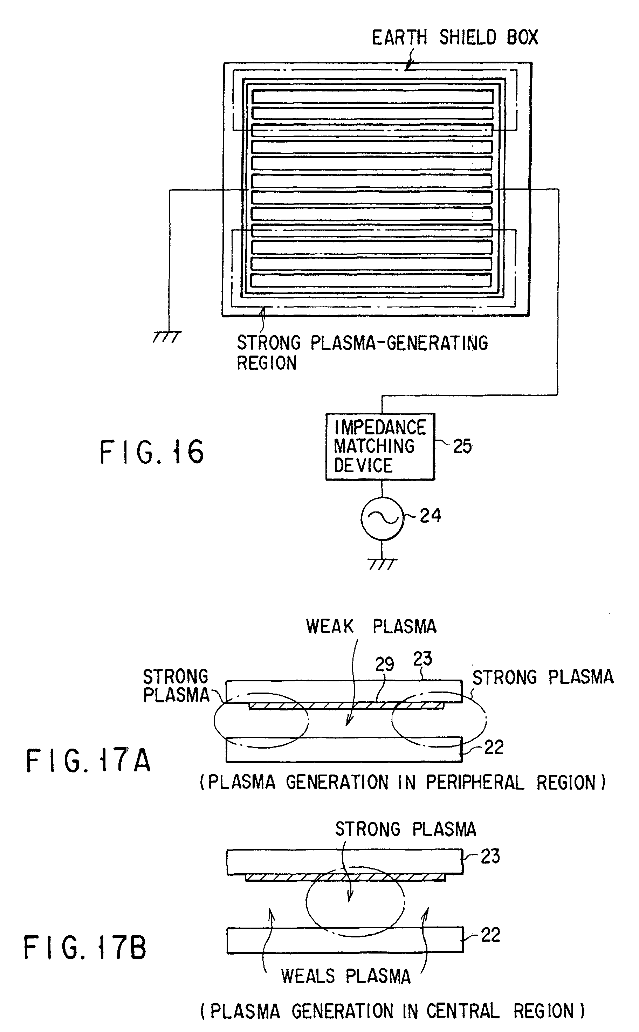

The reason why it is difficult to increase the frequency of the high frequency power source 4 in the apparatus using a ladder-shaped electrode is as follows. Specifically, non-uniformity of impedance derived from the construction of the ladder-shaped electrode is inherent in the apparatus shown in FIG. 12, with the result that a strong plasma light emission is localized, as shown in FIG. 16. For example, a strong plasma is generated in a peripheral portion alone of the ladder-shaped electrode, and is not generated in a central portion. The difference in the plasma density between the peripheral portion and the central portion of the ladder-shaped electrode is rendered prominent particularly where the frequency of the high frequency power source is increased to 60 MHz or more.

Under the circumstances, it is very difficult and considered substantially impossible to increase the film forming rate by increasing the frequency of the plasma power source when it comes to a large substrate required for improving the mass productivity and cost reduction. It should be noted that the film forming rate of a-Si is proportional to the square of the frequency of the plasma power source. Therefore, vigorous researches are being made in this technical field on the technology to increase the frequency of the plasma power source. However, a successful result has not yet been reported in the case of a large substrate.

(2) In the apparatus shown in FIG. 14, a reactant gas, e.g., SiH₄, is decomposed by an electric field generated in the free space between the high frequency electrode 22 and the substrate heater 23 into Si, SiH, SiH₂, SiH₃, H, H₂, etc. so as to form an a-Si film on the surface of the substrate 29. However, if the frequency of the high frequency power is increased from the present level of 13.56 MHz to 30 to 200 MHz in an attempt to increase the rate of forming the a-Si film, the electric field generated in the free space between the high frequency electrode 22 and the substrate heater 23 fails to be distributed uniformly, leading to a markedly poor uniformity in the thickness of the formed a-Si film. FIG. 15 is a graph showing the relationship between the plasma power source frequency and the film thickness distribution in respect of a substrate having an area of 30 cm × 30 cm. It should be noted that the size of the substrate which permits ensuring a uniformity in the film thickness distribution, i.e., deviation of ±10% from an average film thickness, is 5 cm × 5 cm to 20 cm × 20 cm.

The reason why it is difficult to increase the frequency of the high frequency power source 24 in the apparatus using plate electrodes arranged in parallel is as follows. Specifically, the peripheral portion and the central portion of the parallel plate type electrodes differ from each other in the electrical characteristics, with the result that a strong plasma is generated in the peripheral portions of the parallel electrodes 22 and 23 as shown in FIG. 17A, or a strong plasma is generated in the central portion alone of the parallel electrodes 22 and 23 as shown in FIG. 17B.

Under the circumstances, it is very difficult and considered substantially impossible to increase the film forming rate by increasing the frequency of the plasma power source when it comes to a large substrate required for improving the mass productivity and cost reduction. It should be noted that the film forming rate of a-Si is proportional to the square of the frequency of the plasma power source. Therefore, vigorous researches are being made in this technical field on the technology to increase the frequency of the plasma power source. However, a successful result has not yet been reported in the case of a large substrate.

It has also been found that, if the ground wire 7 is connected to the ladder-shaped electrode 2 as shown in FIG. 12, the generated plasma is weakened at the junction between the ground wire 7 and the ladder-shaped electrode 2, leading to reduction in the film forming rate.

An object of the present invention is to provide a plasma CVD apparatus, in which a power supply line joining a ladder-shaped electrode for the discharge generation and a power source is formed of a coaxial cable, and the ladder-shaped electrode is not connected to the ground via a ground wire so as to prevent the film forming rate from being lowered.

Another object is to provide a plasma CVD apparatus, in which at least four coaxial cables are joined to peripheral portions of a ladder-shaped plan coil electrode to form power supply terminal, thereby to make it possible to obtain a satisfactory film thickness distribution, compared with the prior art.

According to one embodiment of the present invention, there is provided a plasma CVD apparatus for forming an amorphous thin film, a microcrystalline thin film or a polycrystalline thin film on a surface of a substrate, comprising a reaction vessel in which the substrate is arranged, means for introducing a reactant gas into the reaction vessel and for discharging the waste gas from within the reaction vessel, a ladder-shaped electrode housed in the reaction vessel for generating discharge, and a power source for supplying electric power to the ladder-shaped electrode to permit the ladder-shaped electrode to generate a glow discharge, wherein a power supply line joining the ladder-shaped electrode and the power source is formed of a coaxial cable, and the ladder-shaped electrode is not connected to the ground via a ground wire.

The ladder-shaped electrode consists of a ladder antenna electrode or a ladder-shaped plan coil electrode.

The invention can be more fully understood from the following detailed description when taken in conjunction with the accompanying drawings, in which:
FIG. 1 shows the entire construction of a plasma CVD apparatus according to one embodiment of the present invention;
FIG. 2 shows the electrical wiring for supplying a high frequency power to the electrode for discharge generation, which is included in the apparatus shown in FIG. 1;
FIG. 3 exemplifies a ladder-shaped electrode used in the present invention, in which a single power supply terminal is formed at a right side and another power supply terminal is formed at a left side, totaling two power supply terminals;
FIG. 4 exemplifies a ladder-shaped electrode used in the present invention, in which two power supply terminals are formed at the right side and two additional power supply terminals are formed at the left side, totaling four power supply terminals;
FIG. 5 exemplifies a ladder-shaped electrode used in the present invention, in which two power supply terminals are formed at the upper side and two additional power supply terminals are formed at the lower side, totaling four power supply terminals;
FIG. 6 exemplifies a ladder-shaped electrode used in the present invention, in which a single power supply terminal is formed at each of the four corners, totaling four power supply terminals;
FIG. 7 exemplifies a ladder-shaped electrode used in the present invention, in which a single power supply terminal is formed at each of the four corners, and a single power supply terminal is formed at each of the right, left, upper and lower sides, totaling eight power supply terminals;
FIG. 8 exemplifies a ladder-shaped electrode used in the present invention, in which a single power supply terminal is formed at each of the four corners, and two power supply terminals are formed at each of the right and left sides, totaling eight power supply terminals;
FIG. 9 exemplifies a ladder-shaped electrode used in the present invention, in which a single power supply terminal is formed at each of the four corners, and two power supply terminals are formed at each of the upper and lower sides, totaling eight power supply terminals;
FIG. 10 shows the relationship between the number of power supply terminals and the film thickness distribution, covering the case where an electric power of 500W having a frequency of 60 MHz is applied to the apparatus of the present invention;
FIG. 11 shows the relationship between the number of power supply terminals and the film thickness distribution, covering the case where an electric power of 500W having a frequency of 80 MHz is applied to the apparatus of the present invention;
FIG. 12 shows the entire construction of a conventional plasma CVD apparatus using a ladder inductance electrode;
FIG. 13 shows the electric wiring for supplying a high frequency power to the electrode for discharge generation included in the apparatus shown in FIG. 12;
FIG. 14 shows the entire construction of a conventional plasma CVD apparatus using plate electrodes arranged in parallel;
FIG. 15 shows the relationship between the frequency of the plasma power source and the film thickness distribution;
FIG. 16 shows the non-uniformity in impedance in the conventional apparatus shown in FIG. 12; and
FIGS. 17A and 17B show the differences in electrical characteristics between the peripheral portion and the central portion of the electrode in the conventional apparatus shown in FIG. 14.

In the present invention, a power supply terminal for supplying a high frequency power to a ladder-shaped electrode is formed at the junction between the ladder-shaped electrode and a coaxial cable used for supplying a high frequency power to the ladder-shaped electrode. It is desirable to form at least four power supply terminals at peripheral portions of the ladder-shaped electrode. To be more specific, it is desirable to form at least two power supply terminals at any of the upper, lower, right and left sides of the ladder-shaped electrode. For example, two power supply terminals should be formed at each of the upper and lower sides of the ladder-shaped electrode, totaling four power supply terminals. Alternatively, four power supply terminals should be formed at each of the right and left sides of the ladder-shaped electrode, totaling eight power supply terminals.

In the present invention, a power supply line connecting the ladder-shaped electrode for discharge generation and the power source is formed of a coaxial cable. Also, the ladder-shaped electrode is not connected to the ground through a ground wire. Because of the particular construction, the plasma CVD apparatus of the present invention makes it possible to prevent a film forming rate from being lowered. It should be noted that the ladder-shaped electrode used in the present invention can be classified into a ladder-antenna electrode and a ladder-shaped plan coil electrode.

In the plasma CVD apparatus of the present invention, power supply terminals which are formed at the junctions between the ladder-shaped electrode and coaxial cables are positioned at peripheral portions of the ladder-shaped electrode. Also, at least four power supply terminals are formed in the ladder-shaped electrode. The particular construction makes it possible to obtain a satisfactory film thickness distribution, compared with the prior art.

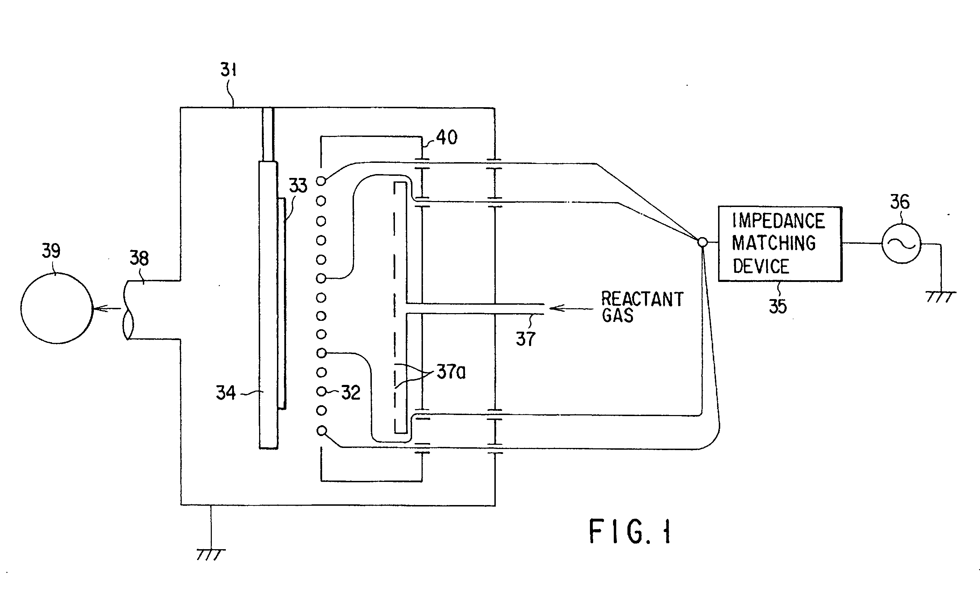

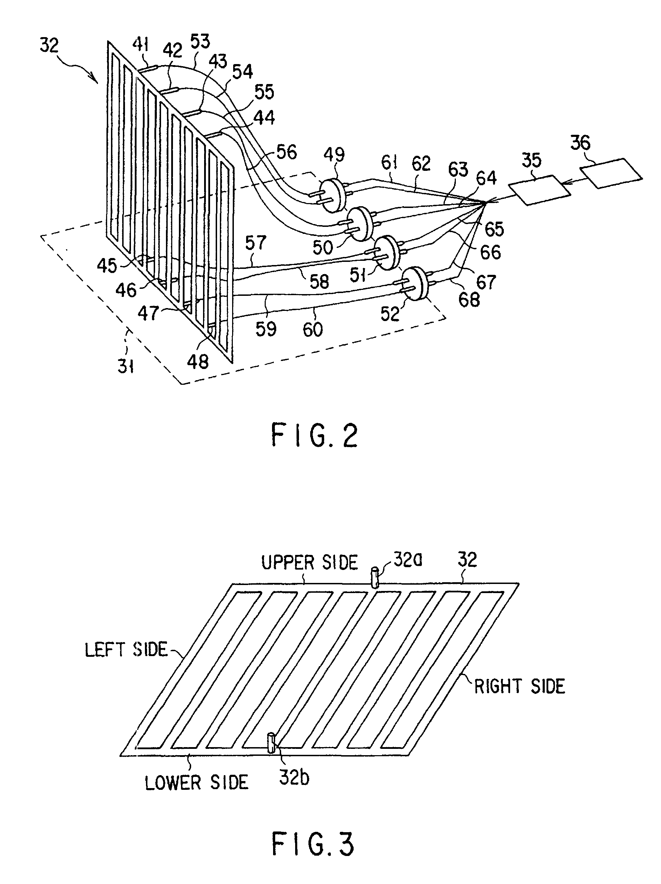

FIGS. 1 and 2 collectively show a plasma CVD apparatus according to one embodiment of the present invention, wherein FIG. 1 shows the entire construction of the apparatus, and FIG. 2 shows the electrical wiring for supplying a high frequency power to the ladder-shaped electrode included in the apparatus shown in FIG. 1.

As shown in the drawings, the plasma CVD apparatus of the present invention comprises a reaction vessel 31. Arranged within the reaction vessel 31 are a discharge electrode (a ladder-shaped electrode) 32 for generating a glow discharge plasma, and a heater 34 supporting a substrate 33 used as a workpiece for controlling the temperature of the substrate 33. The discharge electrode 32 is sized at width 572 mm × length 572 mm and made of a SUS rod having a diameter of 6 mm. The distance between the centers of the adjacent SUS rods is 26 mm.

A high frequency power source 36 is connected to the discharge electrode 32 via an impedance matching device 35. An electric power having a frequency of, for example, 13.56 MHz to 200 MHz is supplied from the high frequency power source 36 to the discharge electrode 32. A reactant gas introducing pipe 37 having a reactant gas discharge port 37a is arranged within the reaction vessel 31 for introducing a reactant gas to a region around the discharge electrode 32. Also, a vacuum pump 39 for discharging the waste gas from within the reaction vessel 31 is connected to the reaction vessel 31 via an exhaust pipe 38.

An earth shield 40 is arranged within the reaction vessel 31. The earth shield 40 serves to suppress the discharge generation in undesired portions. Also, since the earth shield 40 is used in combination with the exhaust pipe 38 and the vacuum pump 39, the earth shield 40 permits the reactant gas and other formed products to be discharged to the outside through the exhaust pipe 38 after the reactant gas such as SiH₄ introduced through the reactant gas introducing pipe 37 into the reaction vessel is converted into a plasma by the electrode 32 for discharge generation. Incidentally, the pressure within the reaction vessel 31 is monitored by a pressure gage (not shown) and controlled by adjusting the exhaust rate of the vacuum pump 39.

As shown in FIG. 2, four power supply terminals 41, 42, 43, 44 are welded to the upper side of the discharge electrode 32. Also, four additional power supply terminals 45, 46, 47, 48 are welded to the lower side of the discharge electrode 32. Four current introducing terminals 49, 50, 51, 52 each having two pins are arranged between the discharge electrode 32 and the impedance matching device 35. In this embodiment, a high frequency power having a frequency of, for example, 60 MHz or 80 MHz is supplied from the high frequency power source 36 to the power supply terminals 41 to 48 through the impedance matching device 35, eight coaxial cables 61, 62, 63, 64, 65, 66, 67, 68, the current introducing terminals 49 to 52, and eight coaxial cables 53, 54, 55, 56, 57, 58, 59, 60 connected to the power supply terminals 41 to 48. In the present invention, it is necessary to use at least four power supply terminals. Also, a ground wire is not connected to the power supply terminals.

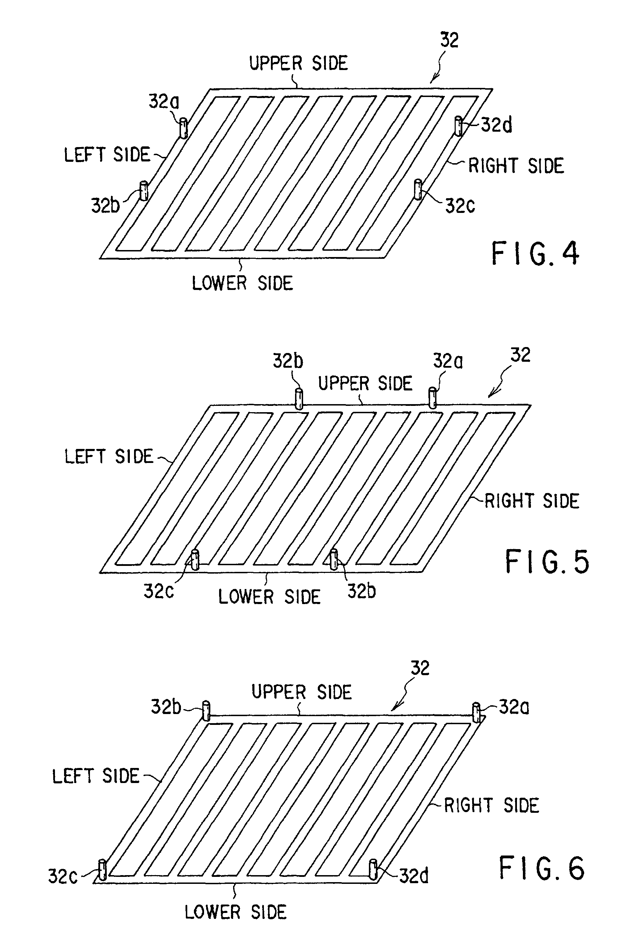

FIGS. 3 to 8 show various ladder-shaped discharge electrodes differing from each other in the position and the number of power supply terminals. Specifically, FIG. 3 shows that a single power supply terminal 32a is formed in a central portion of the upper side of the discharge electrode 32 together with another single power supply terminal 32b formed in a central portion of the lower side of the discharge electrode 32, totaling two power supply terminals 32a and 32b. FIG. 4 shows that two power supply terminals 32a, 32b are formed apart from each other on the left side of the discharge electrode 32 such that the left side of the discharge electrode 32 is equidistantly divided into three sections by these power supply terminals 32a, 32b. Likewise, two power supply terminals 32c, 32d are formed apart from each other on the right side of the discharge electrode 32 such that the right side of the discharge electrode 32 is equidistantly divided into three sections by these power supply terminals 32c, 32d. In short, four power supply terminals 32a, 32b, 32c, 32d are formed in the discharge electrode 32 in the arrangement shown in FIG. 4. FIG. 5 shows that two power supply terminals 32a, 32b are formed apart from each other on the upper side of the discharge electrode 32 such that the upper side of the discharge electrode 32 is equidistantly divided into three sections by these power supply terminals 32a, 32b. Likewise, two power supply terminals 32c, 32d are formed apart from each other on the lower side of the discharge electrode 32 such that the lower side of the discharge electrode 32 is equidistantly divided into three sections by these power supply terminals 32c, 32d. In short, four power supply terminals 32a, 32b, 32c, 32d are formed in the discharge electrode 32 in the arrangement shown in FIG. 5.

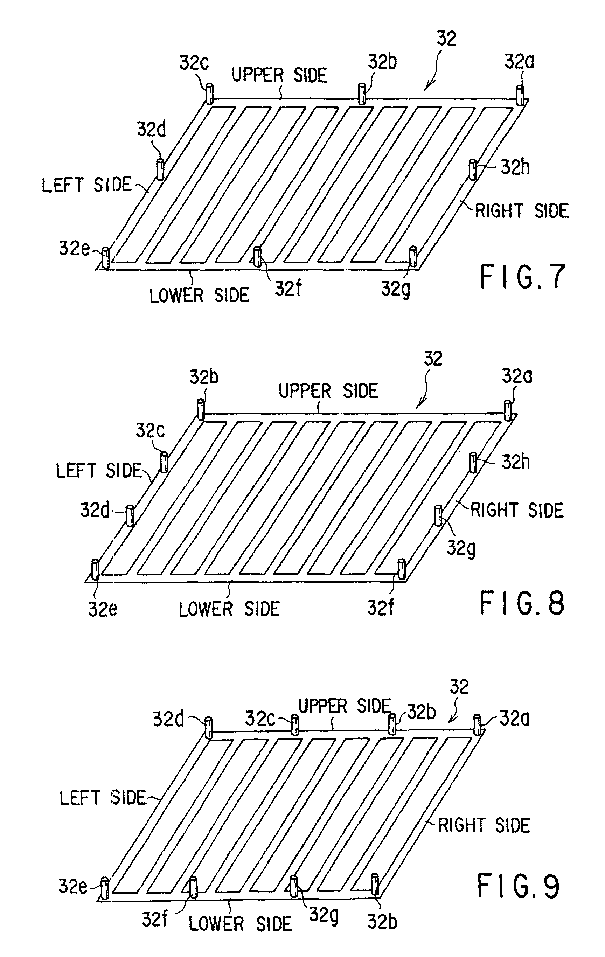

FIG. 6 shows that four power supply terminals 32a, 32b, 32c and 32d are formed in the four corner portions of the discharge electrode 32. FIG. 7 shows that four power supply terminals 32a, 32c, 32e and 32g are formed in the four corner portions of the discharge electrode 32, and that four additional power supply terminals 32b, 32d, 32f and 32h are formed in the central portions of the upper side, left side, lower side and right side of the discharge electrode 32, totaling eight power supply terminals. FIG. 8 shows that four power supply terminals 32a, 32b, 32e and 32f are formed in the four corner portions of the discharge electrode 32, that two additional power supply terminals 32c and 32d are formed apart from each other on the left side of the discharge electrode 32 such that the left side is equidistantly divided by these power supply terminals 32c, 32d into three sections, and that two additional power supply terminals 32g and 32h are formed apart from each other on the right side of the discharge electrode 32 such that the right side is equidistantly divided by these power supply terminals 32g, 32h into three sections. Further, FIG. 9 shows that four power supply terminals 32a, 32d, 32e and 32b are formed in the four corner portions of the discharge electrode 32, that two additional power supply terminals 32b and 32c are formed apart from each other on the upper side of the discharge electrode 32 such that the upper side is equidistantly divided by these power supply terminals 32b, 32c into three sections, and that two additional power supply terminals 32f and 32g are formed apart from each other on the lower side of the discharge electrode 32 such that the lower side is equidistantly divided by these power supply terminals 32f, 32g into three sections.

In forming an a-Si film by using the plasma CVD apparatus of the construction described above, a reactant gas of SiH₄ is converted into a plasma by the discharge from the discharge electrode 32. As a result, radicals within the plasma such as SiH₃, SiH₂, SiH, etc. are diffused so as to be adsorbed on a surface of the substrate 33, leading to deposition of an a-Si film, a microcrystalline Si film or a polycrystalline Si film on the surface of the substrate 33. Incidentally, it is known to the art that an a-Si film, a microcrystalline Si film or a polycrystalline Si film can be formed by controlling appropriately the film forming conditions such as the ratio of flow rate of SiH₄ to H₂, pressure, and plasma generating power. Therefore, let us describe herein the case where an a-Si film is formed by using a SiH₄ gas as a reactant gas. Needless to say, the plasma CVD apparatus of the present invention can also be used for forming a microcrystalline Si film or a polycrystalline Si film.

In the first step, the vacuum pump 39 is operated so as to evacuate the reaction vessel 31 to reach a vacuum of 26,664x10⁻⁶ to 39,997x10⁻⁶. Then, a reactant gas, e.g., SiH₄ gas is introduced through the reactant gas introducing pipe 37 into the reaction vessel at a flow rate of about 80 to 200 cc/mm. Then, a high frequency power is supplied from the high frequency power source 36 to the discharge electrode 32 through the impedance matching device 35 while keeping the inner pressure of the reaction vessel 31 at 6,6661 to 66,661 Pa. As a result, a glow discharge plasma of SiH₄ is generated in the vicinity of the discharge electrode 32. The generated plasma decomposes the SiH₄ gas, leading to formation of an a-Si film on the surface of the substrate 33. It should be noted that the film forming rate, which is also dependent on the frequency and output power of the high frequency power source 36, is about 0.5 to 3 nm/s.

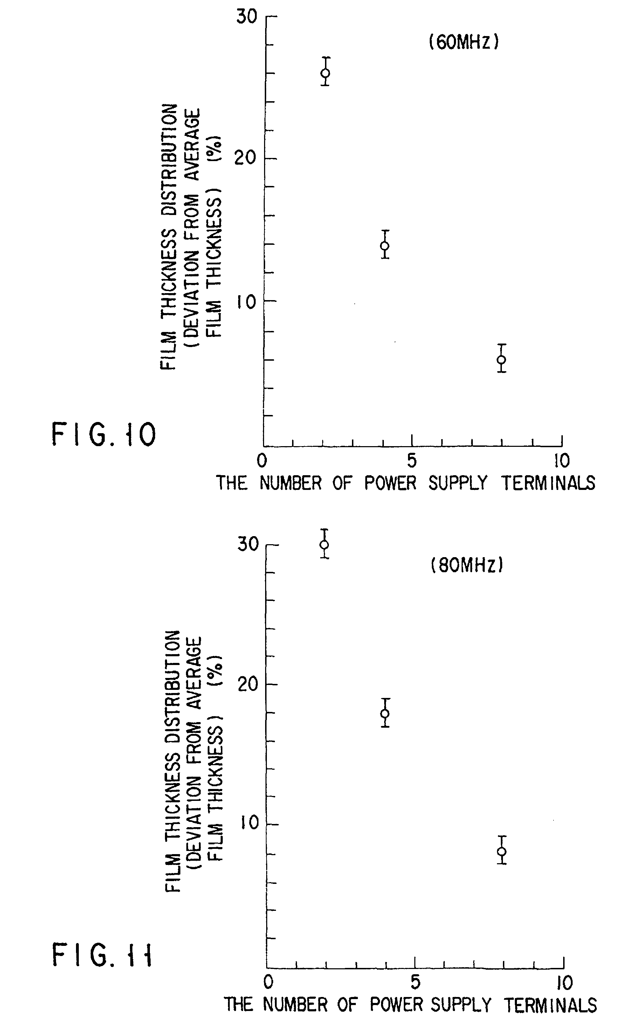

FIG. 10 is a graph showing the experimental data on the relationship between the film thickness distribution and the number of power supply terminals, covering the case where an a-Si film was formed on Corning #7059, which is a trade name of a glass substrate manufactured by Corning Inc., having a surface area of 40 cm × 50 cm, by using the discharge electrodes shown in FIGS. 3 to 9, with the frequency of the high frequency power source 36 set at 60 MHz. In these experiments, the SiH₄ gas flow rate was set at 700 cc/min, the pressure was set at 26,6644 Pa, and the high frequency power was 500W. As shown in FIG. 10, the film thickness deviation from the average thickness was found to be ±26% in the case where the discharge electrode 32 was provided with two power supply terminals. On the other hand, the film thickness deviation from the average thickness was found to be only ±14% in the case where the discharge electrode 32 was provided with four power supply terminals, and as small as ±6% in the case where the discharge electrode 32 was provided with eight power supply terminals.

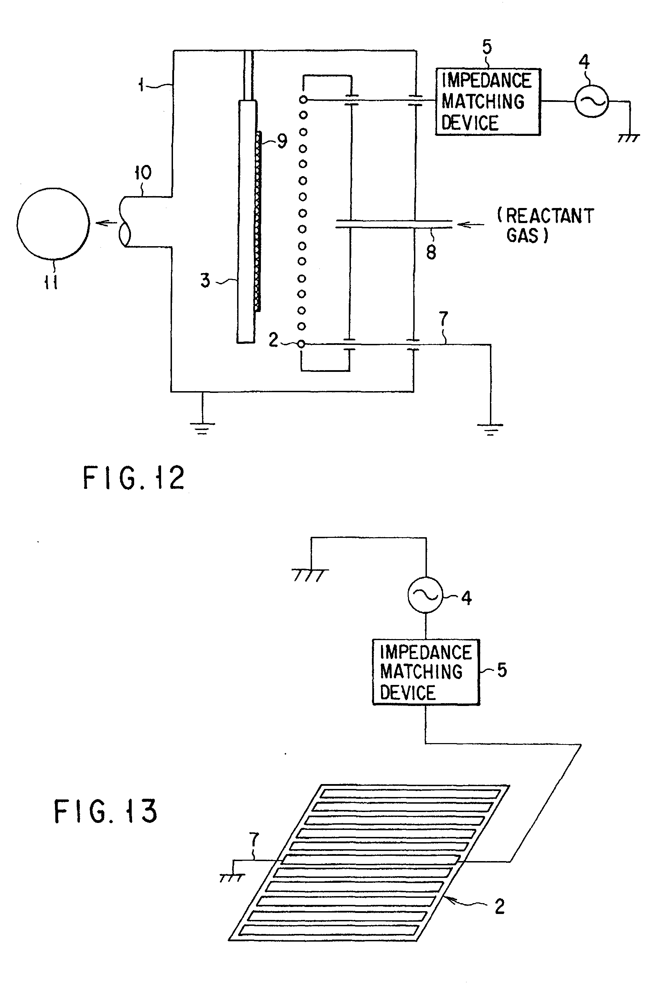

FIG. 11 is a graph showing the experimental data on the relationship between the film thickness distribution and the number of power supply terminals, covering the case where an a-Si film was formed on Corning #7059, which is a trade name of a glass substrate manufactured by Corning Inc., having a surface area of 40 cm × 50 cm, by using the discharge electrodes shown in FIGS. 3 to 9, with the frequency of the high frequency power source 36 set at 80 MHz. In these experiments, the SiH₄ gas flow rate was set at 700 cc/min, the pressure was set at 26,6644 Pa, and the high frequency power was 500W. As shown in FIG. 11, the film thickness deviation from the average thickness was found to be ±30% in the case where the discharge electrode 32 was provided with two power supply terminals. On the other hand, the film thickness deviation from the average thickness was found to be only ±18% in the case where the discharge electrode 32 was provided with four power supply terminals, and as small as ±8% in the case where the discharge electrode 32 was provided with eight power supply terminals.

In the manufacture of an a-Si solar cell, a thin film transistor, a photosensitive drum, etc., no problem in performance is brought about, if the film thickness distribution falls within a range of ±10% of the average thickness.

As apparent from the experimental data, it was possible to obtain a markedly improved film thickness distribution, compared with the conventional apparatus and method, by forming at least four power supply terminals, more preferably at least eight power supply terminals, in the peripheral portions of a ladder-shaped discharge electrode in each of the cases where the frequency of the high frequency power source was set at 60 MHz and 80 MHz. Particularly, where the frequency of the high frequency power source 36 was set at 60 MHz, the thickness distribution of the film formed on a substrate having a surface area of 40 cm × 50 cm was found to be less than ±10% of the average thickness. This clearly supports that the present invention produces a prominently high industrial value in terms of productivity and cost reduction in the manufacture of an a-Si solar cell, a liquid crystal display device driven by a thin film transistor (TFT), and an a-Si photosensitive body.

On the other hand, when it comes to a conventional plasma vapor deposition apparatus, the film thickness distribution is quite non-uniform in the case of using a high frequency power source having a frequency of 30 MHz or more, making it difficult to put the conventional plasma vapor deposition apparatus to practical use in the formation of a thin film on a large substrate sized about 30 cm × 30 cm to 50 cm × 50 cm.

## Claims

1. A plasma CVD apparatus for forming an amorphous thin film, a microcrystalline thin film or a polycrystalline thin film on a surface of a substrate (33), comprising a reaction vessel (31) in which said substrate (33) is arranged, means for introducing a reactant gas into the reaction vessel (31) and for discharging the waste gas from within the reaction vessel (31), a ladder-shaped electrode (32) housed in the reaction vessel (31) for generating discharge, and a power source (36) for supplying electric power in the frequency range of from 13.56 to 200 MHz to the ladder-shaped electrode (32) to permit the ladder-shaped electrode (32) to generate a glow discharge, wherein a power supply line joining the ladder-shaped electrode (32) and the power source (36) is formed of a coaxial cable (61 to 68), and the ladder-shaped electrode (32) is not connected to the ground via a ground wire.

2. The plasma CVD apparatus according to claim 1, **characterized in that** power supply terminals (41 to 48) consisting of the junctions between the ladder-shaped electrode (32) and the coaxial cables (61 to 68) are positioned at peripheral portions of the ladder-shaped electrode (32), and at least'four power supply terminals (41 to 48) are formed in the ladder-shaped electrode (32).

3. The plasma CVD apparatus according to claim 2, **characterized in that** the frequency of the power source (36) for supplying an electric power for generating a glow discharge to the ladder-shaped electrode (32) falls within a range of between 30 MHz and 200 MHz, and a ladder-shaped electrode (32) is used as the glow discharge electrode.

4. The plasma CVD apparatus according to claim 2, **characterized in that** the power supply terminals (41 to 48) are formed in mutually facing sides and/or four corner portions of the ladder-shaped electrode (32) in symmetry in respect of the center of the ladder-shaped electrode (32).

## Patentansprüche

1. Plasma CVD-Vorrichtung zum Bilden eines armorphen Dünnfilms, eines mikrokristallinen Dünnfilms, oder eines polykristallinen Dünnfilms auf einer Oberfläche eines Substrats (33), mit einem Reaktionsbehälter (31), in dem das Substrat (33) angeordnet ist, Mitteln zum Einführen eines Reaktionsgases in den Reaktionsbehälter (31) und zum Ablassen des Abgases aus dem Reaktionsbehälter (31), einer sprossenleiterförmigen Elektrode (32), die in den Reaktionsbehälter (31) zur Erzeugung einer Entladung eingebaut ist, und eine Spannungsquelle (36) zum Zuführen elektrischer Spannung in dem Frequenzbereich von 13,56 bis 200 MHz zu der sprossenleiterförmigen Elektrode (32), um zu ermöglichen das die sprossenleiterförmige Elektrode (32) eine Glimmentladung generiert, wobei eine Spannungszufuhrleitung mit der sprossenleiterförmigen Elektrode (32) verbunden ist und die Spannungsquelle (36) aus einem Koaxialkabel (61-68) gebildet ist, und die sprossenleiterförmige Elektrode (32) nicht mit der Masse über ein Massekabel verbunden ist.

2. Plasma CVD-Vorrichtung nach Anspruch 1, **dadurch gekennzeichnet, dass** die Spannungsversorgungsanschlüsse (41-48), die aus den Verbindungen zwischen der sprossenleiterförmigen Elektrode (32) und den Koaxialkabeln (61-68) bestehen, an peripheren Abschnitten der sprossenleiterförmigen Elektrode (32) positioniert sind, und mindestens vier Versorgungsanschlüsse (41-48) in der sprossenleiterförmigen Elektrode (32) gebildet sind.

3. Plasma CVD-Vorrichtung nach Anspruch 2, **dadurch gekennzeichnet, dass** die Frequenz der Spannungsquelle (36) zum Einspeisen an elektrische Spannung zur Erzeugung einer Glimmentladung an die sprossenleiterförmige Elektrode (32) in einem Bereich zwischen 30 MHz und 200 MHz liegt, und eine sprossenleiterförmige Elektrode (32) als die Glimmentladungselektrode verwendet wird.

4. Plasma CVD-Vorrichtung nach Anspruch 2, **dadurch gekennzeichnet, dass** die Spannungsversorgungsanschlüsse (41-48) in gegenüberliegenden Seiten und/oder vier Kantenabschnitten der sprossenleiterförmigen Elektrode (32) symmetrisch in Bezug auf das Zentrum der sprossenleiterförmigen Elektrode (32) gebildet sind.

## Revendications

1. Appareil de dépôt CVD assisté par plasma pour former un film fin amorphe, un film fin monocristallin ou un film fin polycristallin sur une surface ou un substrat (33), comportant une cuve de réaction (31) dans laquelle est placé ledit substrat (33), des moyens pour introduire un gaz de réaction dans la cuve de réaction (31) et pour évacuer le gaz épuisé hors de la cuve de réaction (31), une électrode (32) en forme d'échelle disposée à l'intérieur de la cuve de réaction (31) pour produire une décharge et une source de courant (36) pour alimenter en courant électrique, avec une fréquence comprise dans une plage allant de 13,56 à 200 MHz, l'électrode et permettre à celle-ci de générer une décharge luminescente, dans lequel une ligne d'alimentation en courant qui relie l'électrode (32) en forme d'échelle à la source de courant (36) est formée d'un câble coaxial (61 à 68) et l'électrode (32) en forme d'échelle est connectée à la masse au moyen d'un fil de masse.

2. Appareil de dépôt CVD assisté par plasma selon la revendication 1, **caractérisé en ce que** les bornes (41 à 48) d'alimentation en courant électrique, qui sont formées par les connections entre l'électrode (32) en forme d'échelle et les câbles coaxiaux (61 à 68), sont disposées dans des zones périphériques de l'électrode (32) en forme d'échelle et **en ce qu'**au moins quatre bornes (41 à 48) d'alimentation en courant électrique sont aménagées dans l'électrode (32) en forme d'échelle.

3. Appareil de dépôt CVD assisté par plasma selon la revendication 2, **caractérisé en ce que** la fréquence de la source de courant (36) fournissant à l'électrode (32) en forme d'échelle un courant électrique pour générer une décharge luminescente est comprise dans une plage allant de 30 MHz à 200 Mhz et **en ce qu'**on utilise une électrode (32) en forme d'échelle comme électrode de décharge luminescente.

4. Appareil de dépôt CVD assisté par plasma selon la revendication 2, **caractérisé en ce que** les bornes (41 à 48) d'alimentation en courant électrique sont aménagées dans des faces mutuellement en vis-àvis et/ou dans la région des quatre angles de l'électrode (32) en forme d'échelle, de manière symétrique par rapport au centre de l'électrode (32) en forme d'échelle.
